Europäisches Patentamt

European Patent Office

Office européen des brevets

(11) Veröffentlichungsnummer: **0 257 342 B1**

## (12) EUROPÄISCHE PATENTSCHRIFT

(45) Veröffentlichungstag der Patentschrift: **02.01.92**

(51) Int. Cl.[5]: **G01R 33/035**

(21) Anmeldenummer: **87111080.5**

(22) Anmeldetag: **30.07.87**

(54) **SOUID-Magnetometer für eine ein- oder mehrkanalige Vorrichtung zur Messung sehr schwacher Magnetfelder.**

(30) Priorität: **13.08.86 DE 3627418**

(43) Veröffentlichungstag der Anmeldung:
**02.03.88 Patentblatt 88/09**

(45) Bekanntmachung des Hinweises auf die Patenterteilung:
**02.01.92 Patentblatt 92/01**

(84) Benannte Vertragsstaaten:
**DE FR IT NL**

(56) Entgegenhaltungen:
**EP-A- 0 111 827**
**EP-A- 0 184 670**
**EP-A- 0 185 186**

**CRYOGENICS, Band 18, Nr. 7, 1978, Seiten 427-431, IPC Business Press, GB; M. ODEHNAL et al.: "Low-level SOUID magnetometry of the human heart in a small ferromagnetic enclosure"**

**JOURNAL OF APPLIED PHYSICS, Band 48, Nr. 2, Februar 1977, Seiten 702-710, American Institute of Physics, New York, US; J.E. ZIMMERMAN: "SOUID instruments and shielding for low-level magnetic measurements"**

(73) Patentinhaber: **SIEMENS AKTIENGESELLSCHAFT**
**Wittelsbacherplatz 2**
**W-8000 München 2(DE)**

(72) Erfinder: **Daalmans, Gabriel M., Dipl.-Ing.**
**Ungarnstrasse 11**
**W-8520 Erlangen(DE)**

## Beschreibung

Die Erfindung bezieht sich auf ein SQUID-Magnetometer für eine Vorrichtung zur ein- oder mehrkanaligen Messung sehr schwacher, von mindestens einer zu detektierenden Feldquelle hervorgerufener Magnetfelder mit mindestens zwei supraleitenden Gradiometerschleifen und zwei Josephson-Tunnelelementen, die mit den Gradiometerschleifen unter Ausbildung eines Gleichstrom-SQUIDs (galvanisch) zusammengeschaltet und mit diesen gemeinsam auf einer Fläche eines starren Trägers angeordnet sind. Ein derartiges Magnetometer geht aus der Veröffentlichung "IEEE Transactions on Magnetics", Vol. MAG-19, No. 3, Mai 1983, Seiten 648 bis 651 hervor.

Zur Messung sehr schwacher Magnetfelder ist eine Verwendung von supraleitenden Quanten-Inferferometern, auch als "SQUIDs" (Abkürzung von: "Superconducting QUantum Interference Devices") bezeichnet, allgemein bekannt ("J.Phys.E.: Sci.Instrum.", Vol. 13, 1980, Seiten 801 bis 813 oder "IEEE Trans.Electron Dev.", Vol. ED-27, No. 10, Okt. 1980, Seiten 1896 bis 1908). Als ein bevorzugtes Anwendungsgebiet für diese Interferometer wird deshalb auch auf dem Gebiet der medizinischen Technik die Magnetokardiographie oder Magnetoenzephalographie angesehen, da die von magnetischen Herz- bzw. Gehirnwellen hervorgerufenen Magnetfelder Feldstärken in der Größenordnung von nur etwa 50 pT bzw. 0,1 pT hervorrufen ("Biomagnetism - Proceedings Third International Workshop on Biomagnetism, Berlin 1980", Berlin/ New York 1981, Seiten 3 bis 31). Diese Felder müssen jedoch bei Anwesenheit von verhältnismäßig großen Störfeldern zu detektieren sein.

Zur Messung von biomagnetischen Feldern in der genannten Größenordnung sind Meßvorrichtungen bekannt, die einkanalig (vgl. z.B. "Cryogenics", Jul. 1978, Seiten 427 bis 431) und insbesondere auch mehrkanalig (vgl. z.B. EP-A-0111 827) ausgeführt sein können. Diese Vorrichtungen enthalten je nach Anzahl der Kanäle mindestens ein SQUID-Magnetometer mit einem Gradiometer erster oder höherer Ordnung.

Entsprechende Magnetometer gehen aus der eingangs genannten Literaturstelle "IEEE Trans.Magn." hervor. Bei einer speziellen Ausführungsform mit einem Gradiometer erster Ordnung ist eine Doppelschleife aus supraleitenden Leitern mit der Gestalt etwa einer "8" vorgesehen. In einer gemeinsamen Verbindungsleitung der beiden Schleifen dieser Doppelschleife sind zwei Josephson-Tunnelelemente integriert, wodurch sich der charakteristische Aufbau eines Gleichstrom-SQUIDs ergibt. Zur Ausbildung von integrierten Gleichstrom-SQUID-Magnetometern zweiter oder höherer Ordnung können die beiden Schleifen der Doppelschleife des bekannten Gradiometers erster Ordnung jeweils durch eine entsprechende Anzahl von Doppelschleifen ersetzt werden. Alle supraeitenden Teile dieser bekannten SQUID-Magnetometer sind dabei auf einer Flachseite eines ebenen Trägers aufgebracht. Mit einem derartigen planaren SQUID-Magnetometer ist zwar eine gute Störfeldunterdrückung möglich. Es ist jedoch verhältnismäßig unempfindlich, da mit den beiden unmittelbar benachbarten Schleifen seiner Doppelschleife nur der Gradient des zu messenden Magnetflusses, nicht aber der Fluß selbst detektiert wird. Ein Vorteil eines planaren SQUID-Magnetometers ist aber, daß es verhältnismäßig einfach herzustellen ist (vgl. z.B. auch die EP-A-0 111 827).

Neben derartigen planaren SQUID-Magnetometern sind auch solche bekannt, deren Gradiometer eine ausgeprägt dreidimensionale Gestalt aufweisen (vgl. z.B. die Veröffentlichung "Rev.Sci. Instrum.", Vol. 53, Dez. 1982, No. 12, Seiten 1815 bis 1845 oder die EP-A-0 184 670). Die Gradiometer bilden dabei einen sogenannten Flußtransformator, der mindestens zwei Gradiometerschleifen enthält. Dabei wird die der zu detektierenden magnetischen Feldquelle zugewandte Schleife auch als Detektionsschleife bezeichnet, während die davon räumlich weiter entfernte Schleife als eine Kompensationsschleife angesehen werden kann. Entsprechende Gradiometer lassen sich z.B. dadurch herstellen, daß man die Gradiometerschleifen in beabstandeter Lage mit den zwischen ihnen verlaufenden Verbindungsleitern auf einem flexiblen, zunächst ebenen Substratkörper, insbesondere auf einer speziellen Folie, aufbringt. Anschließend wird dann der Substratkörper mit den aufgebrachten Leiterteilen zu der gewünschten dreidimensionalen Gradiometerstruktur mit räumlich hintereinander angeordneter Detektions- und Kompensationsschleife gebogen (vgl. die EP-A-0 185 186). Mit einer solchen Schleifenanordnung ist vorteilhaft direkt der magnetische Fluß der Feldquelle zu messen, wobei eine sehr hohe Empfindlichkeit und eine gute Diskriminierung von äußeren Störfeldern zu erreichen ist. Jedoch wird bei derartigen Flußtransformatoren der detektierte Fluß jeweils über eine mit den Gradiometerschleifen verbundene Koppelschleife induktiv in eine SQUID-Schleife eingekoppelt. Wegen der damit verbundenen Verluste müssen deshalb die Gradiometerschleifen verhältnismäßig große Abmessungen haben. Dies führt jedoch zu einer unerwünscht großen Induktivität der einzelnen Schleifen.

Aufgabe der vorliegenden Erfindung ist es deshalb, das SQUID--Magnetometer der eingangs genannten Art derart auszugestalten, daß mit ihm bei verhältnismäßig kleinen Abmessungen der Gradiometerschleifen eine hohe Empfindlichkeit und eine gute Unterdrückung von äußeren Störfeldern erreicht wird. Außerdem soll das Magnetometer verhältnismäßig einfach zu fertigen sein.

Diese Aufgabe wird erfindungsgemäß mit den im kennzeichnenden (zweiten) Teil des Anspruchs 1 angegebenen Maßnahmen gelöst.

Das erfindungsgemaße SQUID-Magnetometer stellt also einen Sensor mit dreidimensionaler Gestalt dar. Mit diesem Magnetometer wird nicht der Gradient des magnetischen Flusses, sondern der Fluß selbst gemessen. Deshalb ist das Magnetometer wesentlich empfindlicher als das bekannte planare SQUID-Magnetometer. Außerdem kann es ebensogut externe Störfelder unterdrücken wie das bekannte Magnetometer. Als Vorteil gegenüber der bekannten Anordnung von einem Flußtransformator mit einem induktiv angekoppelten SQUID ist unter anderem die verhältnismäßig einfache Herstellung zu sehen. Außerdem ist eine gute Flußankopplung gewährleistet. Ein solches Gradiometer mit vorbestimmten Innenabmessungen seiner Schleifen koppelt nämlich wesentlich mehr magnetischen Fluß in das SQUID als dies mit einem Flußtransformator mit entsprechenden Abmessungen seiner Schleifen und einem einteiligen SQUID möglich ist. Mit erfindungsgemäßen Magnetometern können deshalb vorteilhaft mehrkanalige Meßvorrichtungen aufgebaut werden, da auf einer vorgegebenen Fläche einer solchen Vorrichtung bei gleichbleibender Anzahl der Magnetometer die Abstände zwischen den Detektionsschleifen aus benachbarten Magnetometern entsprechend größer auszubilden und damit eine gegenseitige Kopplung der Magnetometer entsprechend zu vermindern ist.

Im Hinblick auf eine hohe Empfindlichkeit des ausgebildeten SQUIDs trotz verhältnismäßig großer Induktivität ist es besonders vorteilhaft, wenn die Josephson-Tunnelelemente in an sich bekannter Weise gegenseitig mittels eines Shuntwiderstandes verkoppelt sind. Eine solche Maßnahme ist im allgemeinen bei Verwendung von schmalen Leiterstücken insbesondere für die Detektionsschleife unbedingt erforderlich. Gegebenenfalls kann auf einen derartigen Shuntwiderstand verzichtet werden, wenn die Detektionsschleife und die Kompensationsschleife jeweils von einem bandförmigen, den Träger in Umfangsrichtung weitgehend umschließenden Leiterstück gebildet sind, dessen Breite wesentlich größer als die Querausdehnung mindestens eines der zwischen diesen Leiterstücken in Längsrichtung des Trägers verlaufenden Verbindungsleiter ist.

Weitere vorteilhafte Ausgestaltungen des erfindungsgemäßen Magnetometers gehen aus den übrigen Unteransprüchen hervor.

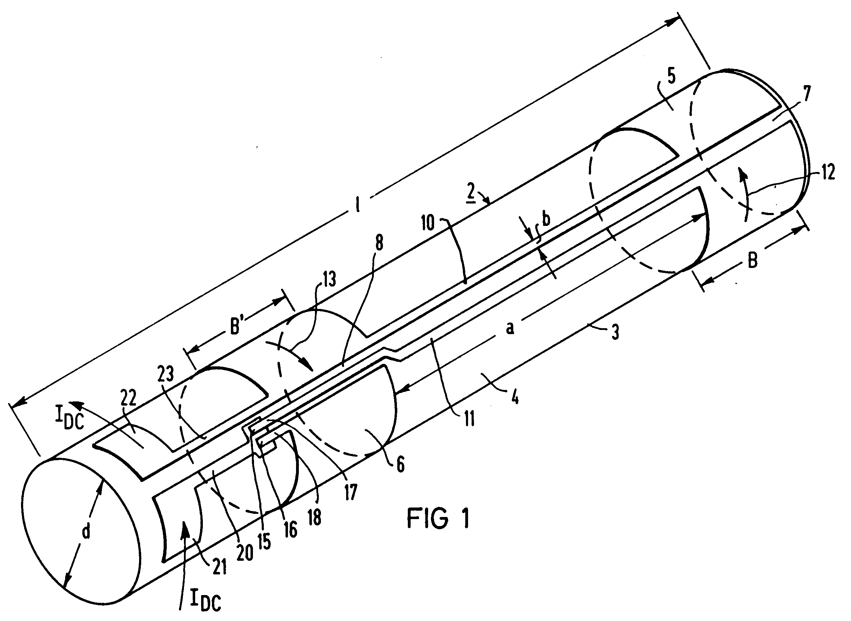

Zur weiteren Erläuterung der Erfindung wird nachfolgend auf die Zeichnung Bezug genommen, in deren Figur 1 ein Ausführungsbeispiel eines erfindungsgemäßen Magnetometers angedeutet ist.

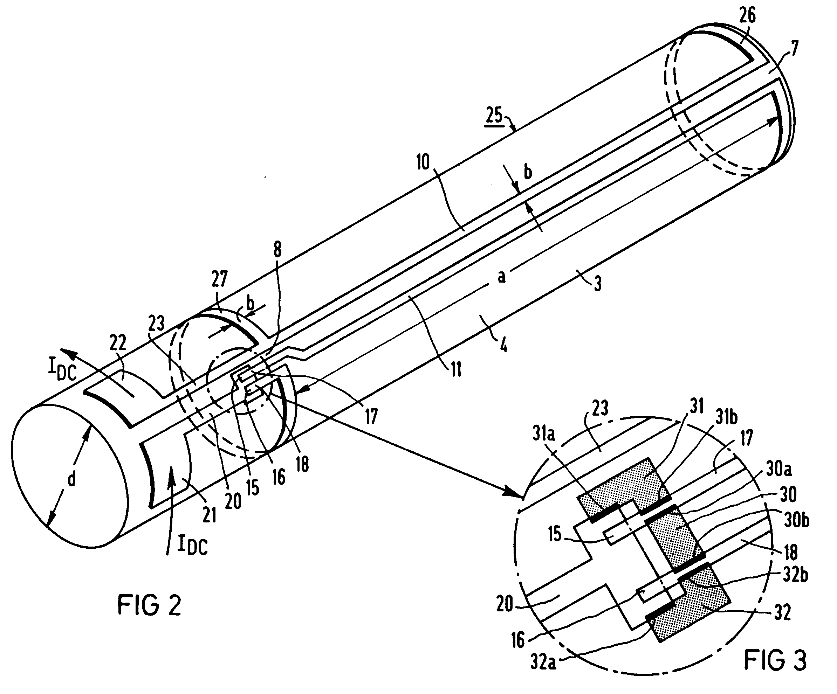

Figur 2 zeigt eine andere Ausbildungsmöglichkeit eines solchen Magnetometers, wobei in Figur 3 ein Ausschnitt aus diesem Magnetometer vergrößert dargestellt ist. In den Figuren sind übereinstimmende Teile mit denselben Bezugszeichen versehen.

Das in Figur 1 in Schrägansicht schematisch gezeigte, allgemein mit 2 gekennzeichnete SQUID-Magnetometer ist auf einem Träger 3 angeordnet. Dieser Träger hat vorzugsweise rohr- oder stabförmige Gestalt mit Durchmesser d und ausgeprägter axialer Ausdehnung l. Er besteht aus einem nicht-magnetischen, isolierenden Material wie z.B. Quarz oder Keramik. Das Magnetometer enthält auf der Außenmantelfläche 4 seines Trägers 3 ein Gradiometer erster Ordnung mit zwei supraleitenden Gradiometerschleifen, von denen eine als Detektionsschleife 5 anzusehen ist. Diese Schleife 5 soll einer zu detektierenden, in der Figur nicht ausgeführten magnetischen Feldquelle zugewandt sein. Sie wird vielfach auch als "Pick-up-Schleife" bezeichnet. Ihr ist eine entsprechende Kompensationsschleife 6 in einem vorbestimmten Abstand a in axialer Richtung entfernt zugeordnet. Diese Schleifen 5 und 6 bestehen jeweils aus einem bandförmigen Leiterstück mit vorbestimmter Breite B bzw. B' in axialer Richtung. Die zu wählende Breite B zumindest für die Schleife 5 ist dabei abhängig vom Durchmesser d des Trägers 3. Vorteilhaft wird ein Wert gewählt, für den gilt:

$0,5 \ d \leq B \leq 1,5 \ d$. Die beiden bandförmigen Leiterstücke der Schleifen 5 und 6 umschließenden Träger 3 in Umfangsrichtung weitgehend, wobei jeweils ein schmaler Schlitz 7 bzw. 8 in axialer Richtung ausgebildet ist. An diese Schlitze begrenzenden Randbereichen der Leiterstücke sind die Schleifen 5 und 6 mit schmäleren, bandförmigen Verbindungsleitern 10 und 11 verbunden. Mit diesen ebenfalls aus supraleitendem Material bestehenden Leitern 10 und 11 sind dabei die Schleifen 5 und 6 so hintereinandergeschaltet, daß sich auf ihnen in Umfangsrichtung entgegengesetzt verlaufende Stromflußrichtungen einstellen können. Diese Stromflußrichtungen sind durch gepfeilte Linien 12 bzw. 13 veranschaulicht. Die in Umfangsrichtung des Trägers 3 zu messende Querausdehnung der in axialer Richtung verlaufenden Verbindungsleiter 10 und 11 ist mit b gekennzeichnet.

Außerdem umfaßt das Magnetometer 2 noch ein in das Gradiometer integriertes Gleichstrom-SQUID mit zwei Josephson-Tunnelelementen 15 und 16. Diese Elemente befinden sich axial hinter der Kompensationsschleife 6 auf deren der Detektionsschleife 5 abgewandten Seite. Sie sind am Ende 17 des durch den Schlitz 8 der Kompensationsschleife 6 hindurchgeführten, von der Detektionsschleife 5 kommenden Verbindungsleiters 11 und einem parallel dazu verlaufenden axialen Verlängerungsstück 18 der Kompensationsschleife 6 ausgebildet. Hierbei ist als eine gemeinsame Elektrode dieser Tunnelelemente 15 und 16 ein entsprechend gestaltetes Endstück eines Anschlußleiters 20 gebildet. Über eine Kontaktfläche 21 kann in diesen Anschlußleiter und damit in die Tunnelelemente ein Strom $I_{DC}$ eingespeist werden, der auch als "BIAS-Strom" bezeichnet wird. Zur Abführung dieses zur Einstellung des SQUIDs erforderlichen Stromes ist ferner noch eine weitere Kontaktfläche 22 vorgesehen, welche sich am Ende eines über die Kompensationsschleife 6 hinaus verlängerten Leiterstücks 23 des Verbindungsleiters 10 befindet.

Gemäß dem in Figur 1 gezeigten besonderen Ausführungsbeispiel des erfindungsgemäßen Magnetometers 2 soll zur Begrenzung der SQUID-Induktivität zumindest die axiale Breite B des die Detektionsschleife 5 bildenden Leiterstücks wesentlich größer gewählt sein als die Querausdehnung b zumindest eines der Verbindungsleiter 10 oder 11. Dabei wird für das die Kompensationsschleife 6 bildende Leiterstück eine entsprechende oder größere Breite B' vorgesehen. Vorzugsweise sollen die Breiten B und B' mindestens 5-mal, vorzugsweise mindestens 10-mal so groß sein wie die Querausdehnung b eines der Verbindungsleiter 10 oder 11.

Zum anderen muß der gegenseitige, axiale Abstand a zwischen der Detektionsschleife 5 und der bezüglich mindestens einer zu detektierenden Feldquelle nachgeordneten Kompensaationsschleife 6 eine vorbestimmte Mindestgröße haben. Diese Größe ist von dem magnetischen Fluß der Feldquelle abhängig, der mit der Detektionsschleife 5 zu erfassen ist. Die Kompensationsschleife 6 soll nun mindestens so weit von der Detektionsschleife 5 entfernt sein, daß der in ihr erfaßte magnetische Fluß der Feldquelle höchstens nur noch 20 %, vorzugsweise maximal 10 % des Flusses beträgt, der mit der Detektionsschleife erfaßt wird.

Mit diesen Maßnahmen läßt sich dann gewährleisten, daß die Induktivität pro Schleife und somit auch die Induktivität des SQUIDs minimal bleiben. Die Konversion $\partial V/\partial\phi$ eines SQUIDs ist nämlich abhängig von der Größe $\beta_L = I_c \cdot (L/\phi_0)$. Dabei sind $I_c$ der kritische Strom des SQUIDs, L die Induktivität des SQUIDs und $\phi_0$ das Flußquant. Die Konversion wird maximal für einen Wert von $\beta_L$ von ungefähr 1 und nimmt mit größerem $\beta_L$ wieder ab (vgl. z.B. "J.Low Temp.Phys.", Vol. 25, Nos. 1/2, 1976, Seiten 99 bis 144). Da im allgemeinen $I_c$ einen Wert von etwa 2 µA nicht unterschreiten darf, wird die maximale SQUID-Induktivität für optimale Konversion etwa 1 nH betragen.

Gemäß einem konkreten Ausführungsbeispiel eines entsprechenden Magnetometers 2 dient als Träger 3 ein Quarzstab mit Durchmesser d von 3 mm. Alle supraleitenden Teile sind dabei als Dünnfilme aus Niob auf diesem Träger abgeschieden.

Die Breite B der Detektionsspule 5 beträgt 3 mm, während die entsprechende, mit B' bezeichnete Breite der Kompensationsspule 6 vorteilhaft größer gewählt wird und beispielsweise 10 mm ist. Der gegenseitige Abstand a der beiden Spulen 5 und 6 soll etwa 5 cm betragen. Die Verbindungsleiter 10 und 11 sind aus etwa 0,3 mm breiten, 0,3 mm beabstandeten Leiterstreifen gebildet, die von einem 0,9 mm breiten Niobstreifen abgeschirmt sind. Die Josephson-Tunnelelemente 15 und 16 weisen jeweils Kontaktflächen von 4 µm$^2$ auf. Der BIAS-Strom $I_{DC}$ wird auf etwa 2 µA eingestellt. Geht man von einer derartigen Ausführungsform aus, so weist die Detektionsspule 5 eine Induktivität von 2 bis 3 nH auf. Man wird also für konkrete Detektionsschleifen das SQUID-Magnetometer bei einem Wert $\beta_L > 1$ betreiben müssen. Wegen der angestrebten hohen Empfindlichkeit des Magnetometers sollte aber der Wert von $\beta_L$ und damit von L möglichst klein sein. Für ein dreidimensionales SQUID-Magnetometer 2, wie es aus der Figur hervorgeht und dem die Werte des konkreten Ausführungsbeispiels zugrundeliegen, kann man dann berechnen, daß die Induktivität etwa 4 nH beträgt wird. Der minimale $\beta_L$-Wert, der sich daraus ergibt, ist demnach 4. Ein derartiges Magnetometer ist folglich in der Lage, Gehirnsignale zu messen, ohne daß eine wesentliche Beimischung von eigenem Rauschen erfolgt.

In Figur 1 wurde der Übersichtlichkeit wegen auf eine Darstellung verzichtet, daß die Verbindungsleiter 10 und 11 vorteilhaft noch von einer gemeinsamen supraleitenden oder auch normalleitenden Fläche mit entsprechender Ausdehnung abgedeckt sein können, wobei diese Abdeckung auch über die Anschlußzonen dieser Leiter mit den Gradiometerschleifen reicht. Es sollen also auch die Schlitze 7 und 8 mit abgedeckt sein. Neben dieser vorteilhaften Ausbildung als Streifenleiter können die streifenförmigen Verbindungsleiter gegebenenfalls auch sich gegenseitig abdecken, d.h. sandwichartig übereinanderliegen. Außerdem kann es vielfach im Hinblick auf eine Begrenzung der Induktivität des Gradiometers vorteilhaft sein, wenn die beiden Josephson-Tunnelelemente 15 und 16 in an sich bekannter Weise gegenseitig mittels eines Widerstandes zur Shuntung der SQUID-Induktivität verkoppelt werden. Ein solcher Shuntwiderstand ist insbesondere bei Gradiometern höherer Ordnung zweckmäßig. Daneben können gegebenenfalls auch die Tunnelelemente jeweils von einem eigenen Shuntwiderstand überbrückt sein.

Aus Figur 2 ist ein weiteres, allgemein mit 25 bezeichnetes SQUID-Magnetometer in Figur 1 entsprechender Darstellung ersichtlich, während in Figur 3 dessen die Josephson-Tunnelelemente 15 und 16 aufweisender Bereich vergrößert wiedergegeben ist. Mit Figur 1 zumindest weitgehend übereinstimmende Teile sind dabei mit den gleichen Bezugzeichen versehen. Das Magnetometer 25 unterscheidet sich von der in Figur 1 gezeigten Ausführungsform des Magnetometers 2 im wesentlichen dadurch, daß nunmehr seine Detektionsschleife 26 und seine Kompensationsschleife 27 nicht wie die Gradiometerschleifen 5 und 6 aus breiteren Leiterstücken gebildet sind, sondern ihre Breite zumindest weitgehend der Querausdehnung b der Verbindungsleiter 10 und 11 entspricht. Eine derartige Ausbildung des Magnetometers 25 macht jedoch Zusatzmaßnahmen zur Aufrechterhaltung der SQUID-Empfindlichkeit bei verhältnismäßig großer Induktivität erforderlich.

Diese Maßnahmen bestehen in Shuntwiderständen an den Josephson-Tunnelelementen 15 und 16 und sind in der in Figur 3 gezeigten Aufsicht angedeutet. Dabei ist ein Widerstand zur Shuntung der SQUID-Induktivität mit 30 bezeichnet. Er verkoppelt die beiden Josephson-Tunnelelemente 15 und 16, indem er zwischen die jeweils eine Elektrode dieser Elemente bildenden Leiterendstücke 17 und 18 des Verbindungsleiters 11 bzw. des Verlängerungsstücks 18 der Kompensationsschleife 27 gelegt ist. Die entsprechende, beispielsweise in Dünnfilmtechnik erstellte Widerstandsbahn ist in Kontaktzonen 30a und 30b mit den Leiterendstücken 17 und 18 verbunden. In der Figur sollen die Kontaktzonen durch verstärkte Linien veranschaulicht sein. Außerdem sind noch Shuntwiderstände 31 und 32 vorgesehen, mit denen die Josephson-Tunnelelemente 15 und 16 überbrückt sind. Diese z.B. ebenfalls durch Widerstandsbahnen gebildeten Widerstände sind dabei jeweils mit den beiden Elektroden eines Josephson-Tunnelelementes verbunden. Die entsprechenden Kontaktzonen 31a und 31b bzw. 32a und 32b sind wiederum durch verstärkte Linien veranschaulicht.

Dem in den Figuren dargestellten Ausführungsbeispielen wurde ein Gradiometer erster Ordnung mit jeweils einer Detektions- und einer Kompensationsspule zugrundegelegt. Ebensogut können jedoch auf dem gemeinsamen Träger auch Gradiometer höherer Ordnung ausgebildet sein, wobei eine entsprechend größere Anzahl von Gradiometerschleifen in bekannter Weise hintereinander anzuordnen sind (vgl. z.B. die genannte Veröffentlichung "Rev.Sci.Instrum.", Seite 1827). Zwar sind für derartige Gradiometer Träger mit zylindrischer Mantelfläche besonders vorteilhaft; gegebenenfalls können jedoch auch Träger mit von einem Kreisquerschnitt abweichender Querschnittsform vorgesehen werden. Die Träger brauchen dabei nicht aus einem einzigen Stück zu bestehen, sondern können gegebenenfalls auch aus mehreren Stükken zusammengesetzt sein.

Die in den Figuren dargestellten SQUID-Magnetometer 2 und 25 stellen jeweils ein Modul für einen Detektionskanal einer Meßeinrichtung dar. Mehrkanalige Vorrichtungen lassen sich dann mit einer entsprechenden Anzahl solcher Magnetometer-Module zu einer gewünschten Reihe (Array) in bekannter Weise zusammensetzen. Da die Querausdehnung bzw. der Durchmesser der Träger und damit der auf ihnen aufgebrachten Schleifen verhältnismäßig klein gehalten werden kann, können vorteilhaft hinreichende Abstände zwischen benachbarten Magnetometern eingehalten werden und kann somit eine gegenseitige magnetische Beeinflussung dieser Magnetometer entsprechend begrenzt werden.

**Patentansprüche**

1. SQUID-Magnetometer (2, 25) für eine Vorrichtung zur ein-oder mehrkanaligen Messung sehr schwacher, von mindestens einer zu detektierenden Feldquelle hervorgerufener Magnetfelder mit mindestens zwei supraleitenden Gradiometerschleifen (5, 6, 26, 27) und zwei Josephson-Tunnelelementen (15, 16), die mit den Gradiometerschleifen unter Ausbildung eines Gleichstrom-SQUIDs galvanisch zusammengeschaltet und mit diesen gemeinsam auf einer Fläche (4) eines starren Trägers (3) angeordnet sind, **dadurch gekennzeichnet,**

   - daß sich mindestens eine Detektionsschleife (5, 26) und mindestens eine Kompensationsschleife (6, 27) als die Gradiometerschleifen sowie die beiden Josephson-Tunnelelemente (15, 16) zusammen mit supraleitenden Verbindungsleitern (10, 11) zwischen der Detektionsschleife (5, 26), der Kompensationsschleife (6, 27) und den Josephson-Tunnelelementen (15, 16) hintereinander auf einer eine ausgeprägt dreidimensionale Gestalt aufweisenden Fläche (4) des Trägers (3) befinden, wobei die Gradiometerschleifen (5, 6, 26, 27) sowie die Verbindungsleiter (10, 11) band- oder streifenförmige Leiterstücke sind und wobei das eine Josephson-Tunnelelement (15) an einem mit der Detektionsschleife (5, 26) verbundenen Leiterendstück (17) und das andere Josephson- Tunnelelement (16) an einem mit der Kompensationsschleife (6, 27) verbundenen Leiterendstück (18) ausgebildet sind, und

   - daß der gegenseitige Abstand (a) zwischen der Detektionsschleife (5, 26) und der ihr zugeordneten Kompensationsschleife (6, 27) so groß gewählt ist, daß der von der Kompensationsschleife (6, 27) mit erfaßte magnetische Fluß der zu detektierenden Feldquelle höchstens 20 % des von der Detektionsschleife (5, 26) erfaßten magnetischen Flusses beträgt.

2. Magnetometer nach Anspruch 1, **dadurch gekennzeichnet,** daß der Träger (3) rohr- oder stabförmig gestaltet ist.

3. Magnetometer nach Anspruch 1 oder 2, **dadurch gekennzeichnet,** daß der Träger (3) aus Quarz oder aus einer Keramik besteht.

4. Magnetometer nach einem der Ansprüche 1 bis 3, **dadurch gekennzeichnet,** daß der Abstand (a) zwischen der Detektionsschleife (5, 26) und der ihr zugeordneten Kompensationsschleife (6, 27) so groß gewählt ist, daß der von der Kompensationsschleife (6, 27) erfaßte magnetische Fluß höchstens 10 % des von der Detektionsschleife (5, 26) erfaßten magnetischen Flusses beträgt.

5. Magnetometer nach einem der Ansprüche 1 bis 4, **dadurch gekennzeichnet,** daß die Detektionsschleife (5) und die Kompensationsschleife (6) jeweils von einem den Träger (3) in Umfangsrichtung weitgehend umschließenden Leiterstück gebildet sind, dessen Breite (B bzw. B' ) größer als die Querausdehnung (b) mindestens eines der zwischen diesen Leiterstücken in Längsrichtung des Trägers (3) verlaufenden Verbindungsleiter (10, 11) ist.

6. Magnetometer nach Anspruch 5, **dadurch gekennzeichnet,** daß die axialen Breiten (B, B' ) der die Detektionsschleife (5) bzw. die Kompensationsschleife (6) bildenden Leiterstücke jeweils mindestens 5-mal, vorzugsweise mindestens 10-mal so groß wie die Querausdehnung (b) mindestens eines der Verbindungsleiter (10, 11) ist.

7. Magnetometer nach Anspruch 5 oder 6, **dadurch gekennzeichnet,** daß die Breite (B') des die Kompensationsschleife (6) bildenden Leiterstücks größer als die entsprechende Breite (B) des die Detektionsschleife (5) bildenden Leiterstücks ist.

8. Magnetometer nach Anspruch 2 und 6 oder 7, **dadurch gekennzeichnet,** daß die Breite (B) des die Detektionsschleife (5) bildenden Leiterstücks einen Wert hat, der zwischen dem 0,5-Fachen und dem 1,5-Fachen des Durchmessers (d) des Trägers (3) liegt.

9. Magnetometer nach einem der Ansprüche 1 bis 8, **dadurch gekennzeichnet,** daß die Josephson-Tunnelelemente (15, 16) gegenseitig mittels eines Widerstandes (30) zur Shuntung der SQUID-Induktivität verkoppelt sind.

10. Magnetometer nach einem der Ansprüche 1 bis 9, **dadadurch gekennzeichnet,** daß die Josephson-Tunnelelemente (15, 16) jeweils mittels eines Shuntwiderstandes (31, 32) überbrückt sind.

11. Magnetometer nach einem der Ansprüche 1 bis 10, **dadurch gekennzeichnet,** daß die Gradiometerschleifen (5, 6, 26, 27), die Verbindungsleiter (10, 11) sowie die Elektroden der Josephson-Tunnelelemente (15, 16) aus dünnen Niob-Filmen bestehen.

12. Magnetometer nach einem der Ansprüche 1 bis 11, **dadurch gekennzeichnet,** daß eine metallische Abdeckung der Verbindungsleiter (10, 11) bis in ihren Verbindungsbereich mit den zugehörenden Gradiometerschleifen (5, 6, 26, 27) vorgesehen ist.

**Claims**

1. SQUID magnetometer (2, 25) for a device for the single or multi-channel measurement of very weak magnetic fields caused by at least one field source to be detected, having at least two superconducting gradiometer loops (5, 6, 26, 27) and two Josephson tunnel elements (15, 16) which are galvanically connected to the gradiometer loops, thereby forming a d-c SQUID, and are arranged on a surface (4) of a rigid carrier (3) common to these, characterised in that

   - at least one detection loop (5, 26) and at least one compensation loop (6, 27) as the gradiometer loops, and the two Josephson tunnel elements (15, 16) together with superconducting connecting conductors (10, 11) are located between the detection loop (5, 26), the compensation loop (6, 27) and the Josephson tunnel elements (15, 16) one behind the other on a surface (4) of the carrier (3) having a marked three-dimensional shape, the gradiometer loops (5, 6, 26, 27) and the connecting conductors (10, 11) being band or strip-shaped conductor pieces, and one Josephson tunnel element (15) being formed on a conductor end piece (17) connected to the detection loop (5, 26) and the other Josephson tunnel element (16) being formed on a conductor end piece (18) connected to the compensation loop (6, 27),

and

- in that the mutual distance (a) between the detection loop (5, 26) and the compensation loop (6, 27) associated with it are selected to be sufficiently large that the magnetic flux of the field source to be detected, sensed by the compensation loop (6, 27) amounts at the most to 20% of the magnetic flux sensed by the detection loop (5, 26).

2. Magnetometer according to claim 1, characterised in that the carrier (3) is tubular or rod-shaped.

3. Magnetometer according to claim 1 or 2, characterised in that the carrier (3) is of quartz or ceramic.

4. Magnetometer according to one of claims 1 to 3, characterised in that the distance (a) between the detection loop (5, 26) and the compensation loop (6, 27) associated with it is selected to be sufficiently large that the magnetic flux sensed by the compensation loop (6, 27) amounts at the most to 10% of the magnetic flux sensed by the detection loop (5, 26).

5. Magnetometer according to one of claims 1 to 4, characterised in that the detection loop (5) and the compensation loop (6) are respectively formed by a conductor piece substantially surrounding the carrier (3) in the circumferential direction, the width (B or B') of this conductor piece being greater than the cross-sectional dimension (b) of at least one of the connecting conductors (10, 11) extending between these conductor pieces in the longitudinal direction of the carrier (3).

6. Magnetometer according to claim 5, characterised in that the axial widths (B, B') of the conductor pieces forming the detection loop (5) or the compensation loop (6) are respectively at least 5 times, preferably at least 10 times, as great as the cross-sectional dimension (b) of at least one of the connecting conductors (10, 11).

7. Magnetometer according to claim 5 or 6, characterised in that the width (B') of the conductor piece forming the compensation loop (6) is greater than the corresponding width (B) of the conductor piece forming the detection loop (5).

8. Magnetometer according to claim 2 and 6 or 7, characterised in that the width (B) of the conductor piece forming the detection loop (5) has a value of between 0.5 and 1.5 times the diameter (d) of the carrier (3).

9. Magnetometer according to one of claims 1 to 8, characterised in that the Josephson tunnel elements (15, 16) are mutually coupled by means of a resistor (30) for shunting the SQUID inductance.

10. Magnetometer according to one of claims 1 to 9, characterised in that the Josephson tunnel elements (15, 16) are respectively bridged by means of a shunt resistor (31, 32).

11. Magnetometer according to one of claims 1 to 10, characterised in that the gradiometer loops (5, 6, 26, 27), the connecting conductors (10, 11) and the electrodes of the Josephson tunnel elements (15, 16) are of thin niobium films.

12. Magnetometer according to one of claims 1 to 11, characterised in that a metallic covering of the connecting conductors (10, 11) is provided up to the region where they connect with the associated gradiometer loops (5, 6, 26, 27).

**Revendications**

1. Magnétomètre à SQUID (2, 25) pour un dispositif pour la mesure à canal unique ou à canaux multiples de champs magnétiques très faibles engendrés par au moins une source de champ magnétique à détecter, avec au moins deux boucles gradiométriques supraconductrices (5, 6, 26, 27) et avec deux éléments tunnel de Josephson (15, 16) qui sont reliés galvaniquement avec les boucles gradiométriques en formant un SQUID à courant continu et qui sont disposés en commun avec celles-ci sur une surface (4) d'un support rigide (3), caractérisé par le fait

- qu'au moins une boucle de détection (5, 26) et au moins une boucle de compensation (6, 27) en tant que boucles gradiométriques, ainsi que les deux éléments tunnel de Josephson (15, 16) se situent ensemble avec des conducteurs de liaison supraconducteurs (10, 11) entre la boucle de détection (5, 26), la boucle de compensation (6, 27) et les éléments tunnel de Josephson (15, 16), successivement sur une surface (4) du support (3), qui présente une forme tridimensionnelle prononcée, les boucles gradiométriques (5, 6, 26, 27) ainsi que les conducteurs de liaison (10, 11) étant constitués par des pièces conductrices en forme de rubans ou de bandes, et un premier élément tunnel de Josephson (15) étant formé sur une pièce conductrice (17) reliée à la boucle de détection (5, 26), alors que l'autre élément tunnel de Josephson (16) est formé sur une pièce conductrice (18) qui est reliée à la boucle de compensation (6, 27)

et

- que la distance mutuelle (a) entre la bouche de détection (5, 26) et la bouche de compensation (6, 27) qui lui est associée est choisie à une valeur assez grande pour que le flux magnétique de la source du champ à détecter, et qui est également saisi par la bouche de compensation (6, 27), soit au plus égal à 20 % du flux magnétique saisi par la boucle de détection (5, 26).

2. Magnétomètre selon la revendication 1, caractérisé par le fait que le support (3) est conformé à la manière d'un tube ou d'une tige.

3. Magnétomètre selon la revendication 1 ou 2, caractérisé par le fait que le support (3) est constitué par du quartz ou par une céramique.

4. Magnétomètre selon l'une des revendications 1 à 3, caractérisé par le fait que la distance (a) entre la boucle de détection (5, 26) et la bouche de compensation (6, 27) qui lui est associée est choisie à une valeur telle que le flux magnétique qui est saisi par la bouche de compensation (6, 27) est au plus égal à 10 % du flux magnétique qui est saisi par la bouche de détection (5, 26).

5. Magnétomètre selon l'une des revendications 1 à 4, caractérisé par le fait que la bouche de détection (5) et la bouche de compensation (6) sont respectivement formées par une pièce conductrice qui entoure largement le support (3) dans le sens périphérique, et dont la largeur (B, B') est supérieure à l'extension transversale (b) d'au moins de l'un des conducteurs de liaison (10, 11) qui s'étendent, entre ces pièces conductrices, dans la direction longitudinale du support (3).

6. Magnétomètre selon la revendication 5, caractérisé par le fait que les largeurs axiales (B, B') des pièces conductrices qui constituent la boucle de détection (5) et la boucle de compensation (6), sont respectivement au moins 5 fois plus grandes, de préférence au moins 10 fois aussi grandes que l'extension transversale (b) d'au moins l'un des conducteurs de liaison (10, 11).

7. Magnétomètre selon la revendication 5 ou 6, caractérisé par le fait que la largeur (B') de la pièce conductrice qui constitue la boucle de compensation (6), est supérieure à la largeur correspondante (B) de la pièce conductrice qui constitue la boucle de détection (5).

8. Magnétomètre selon les revendications 2 et 6 ou 7, caractérisé par le fait que la largeur (B) de la pièce conductrice qui constitue la boucle de détection (5) présente une valeur qui se situe entre 0,5 fois et 1,5 fois le diamètre (d) du support (3).

9. Magnétomètre selon l'une des revendications 1 à 8, caractérisé par le fait que les éléments tunnel de Josephson (15, 16) sont accouplés mutuellement à l'aide d'une résistance (30) en vue de shunter l'inductance du SQUID.

10. Magnétomètre selon l'une des revendications 1 à 9, caractérisé par le fait que les éléments tunnel de Josephson (15, 16) sont shuntés respectivement à l'aide d'une résistance-shunt (31, 32).

11. Magnétomètre selon l'une des revendications 1 à 10, caractérisé par le fait que les boucles gradiométriques (5, 6, 26, 27), les conducteurs de liaison (10, 11) ainsi que les électrodes des éléments tunnel de Josephson (15, 16) sont constitués par des films minces de niobium.

12. Magnétomètre selon l'une des revendications 1 à 11, caractérisé par le fait qu'il est prévu une couverture métallique des conducteurs de liaison (10, 11) jusqu'à leur point de liaison avec les boucles gradiométriques associées (5, 6, 26, 27).

FIG 1

EP 0 257 342 B1

FIG 2

FIG 3

EP 0 257 342 B1